(19) Europäisches Patentamt
European Patent Office
Office européen des brevets

(11) **EP 2 178 214 A1**

(12) **EUROPEAN PATENT APPLICATION**

(43) Date of publication:
**21.04.2010 Bulletin 2010/16**

(51) Int Cl.:
***H03M 13/00*** *(2006.01)*

(21) Application number: **08305689.5**

(22) Date of filing: **16.10.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(71) Applicant: **Thomson Licensing
92443 Issy-les-Moulineaux Cedex (FR)**

(72) Inventors:
• **Theis, Oliver
30655, HANNOVER (DE)**

• **Chen, Xiao-Ming
30165, Hannover (DE)**
• **Georgi, Marco
30855, Langenhagen (DE)**

(74) Representative: **Thies, Stephan
Deutsche Thomson OHG
European Patent Operations
Karl-Wiechert-Allee 74
30625 Hannover (DE)**

(54) **Method and apparatus for algebraic erasure decoding**

(57) For correcting a multibit, LDPC coded codeword where up to two multibit symbols within the codeword are known to be erroneous, a method is proposed, where the position of the erroneous multibit symbols is checked for correctability, the non-erroneous subset of the codeword is GF2-multiplied with a corresponding subset of the parity check matrix of the LDPC code resulting in an interim vector, and the erroneous parts of the codeword are reconstructed such that they, when GF2-multiplied to their associated parts of the parity check matrix, yield the same interim vector.

Figure 5

**Description**

<u>Field of the invention</u>

The invention relates to the field of error correction codes (ECC) for optical storage systems. It may also be applied to magnetic recording storage devices, Redundant Array of Independent Disk (RAID) systems, and transmission systems.

<u>Description</u>

An approach of efficiently encodable quasi-cyclic error correcting codes will be named "zArray Codes" in the following. zArray codes are based on the known "array codes" as published in R.J.G. Smith, "Easily Decodable Efficient Self-Orthogonal Block Codes", Electronics Letters, Vol 13 No. 7, pp173-174, 1977. zArray codes constitute, in a systematic way, ECC codes of type LDPC (Low Density Parity Check), which are, on one hand, efficiently encodable even at large codeword length, and, on the other hand, have a good performance when decoded using message passing algorithms.

Advantages of zArray codes over Array codes:

- By being column regular, zArray codes enable for a better message passing decoding performance than the column-iregular Array codes.
- zArray codes maintain an encoding time that grows linearly with codeword length.
- zArray codes allow parity bit generation, i.e. encoding, to be split into an adjustable number of independent sequential tasks, enabling parallelization of the encoding process.

A parity check matrix of a zArray codes is defined and generated by the following steps: A first intermediate matrix H1 is generated so as to comprise two rows of square, identically sized, binary sub-matrices, where the first row comprises p identity matrices I of size p•p, and the second row comprises p increasing powers $\sigma^u$ of a cyclic shift matrix $\sigma$ of size p•p, wherein u=0,...,p-1. From the first intermediate matrix H1, a second intermediate matrix H2 is generated by removing m equidistant columns from each of the sub-matrices of the first intermediate matrix H1 at column indices (r+i•(2r+1)+q) modulo p, wherein i,m,p,q are integers, wherein i=0,...,m-1, wherein m,p,q,r are predefined such that p=m+2mr, and wherein column indices within the sub-matrices start with 0. From the second intermediate matrix H2, a third intermediate matrix H3 is generated by deleting those matrix rows from the first row of sub-matrices of the second intermediate matrix H2 which, due to the removing step, contain only zeros. As a consequence of this deleting, the first row of the third intermediate matrix H3 comprises p small identity matrices Is of size (p-m)•(p-m). From the third intermediate matrix H3, the parity check matrix H of the zArray code is generated by inserting or appending m-1 binary column vectors of height 2p-m having weight 2, wherein the column vectors have "1" elements in the middle rows of the row ranges of the sub-matrices $[\sigma^0 \sigma^1]$ that have row weight 2. The latter mentioned binary column vectors have together been named the "z" matrix, hence the name of zArray codes. zArray Codes are designed for efficient encodability and good message passing decoding performance. However, message passing decoding is justified only when errors are reflected by low bit reliabilites for the received codeword. This might not be the case for burst error (or erasures representing burst error with known position) or shot noise events.

WO 99/67913 purports to disclose a forward error correction decoder which receives a received word comprising a plurality of characters. The decoder also receives a reliability value for each character. The decoder calculates a syndrome for each member of the set of possible received words by transforming each member with the parity check matrix. Members of the set having the same syndrome are grouped together into cosets. A weight based on the reliability value is then assigned to each member in each coset. The weight is defined to be the number of low-reliability, non-zero characters in each member of the set of possible received words. For each coset, the member that has the lowest weight is selected as a coset leader. A syndrome is computed for the soft codeword by transforming it with the parity check matrix. The coset leader with the same syndrome as the received word is subtracted from the received word resulting in a codeword estimate. This can be seen to have the drawback that using reliability values, as well as calculating syndromes for sets of potential codewords constitutes a considerable processing burden.

An improved error correction decoder is desirable.

In the following, we denote as a "*symbol*" of a zArray codeword the tuple of those *p-m* bits that correspond to those columns of the parity check matrix H that contain the columns of one of the cyclic shift submatrices $\sigma^u$ after column removal. Further, we denote as "*symbol x*" or "*the x-th symbol*" that one of the tuples, which corresponds to the columns of $\sigma^{x-1}$. Note that in this nomenclature, because of their number, those m-1 bits of a codeword that correspond to the z matrix part of the parity check matrix H, are in general not considered a symbol.

In case of a single or double symbol erasure corrupting multiple bits of one or two symbols, message passing decoding will likely fail to find the correct codeword. Algebraic decoding is applied successfully instead, since zArray codes retain most of the structure inherited from Smith's code. This will likely allow correction of single and double symbol erasure(s).

A similar double erasure correcting code has already been invented by M. Blaum with his class of Array Codes in "A CODING TECHNIQUE FOR RECOVERY AGAINST DOUBLE DISK FAILURE IN DISK ARRAYS" in 1992. See US Pat. No. 5,271,012 or EP 0 519 669, respectively. These codes have minimum distance 3 and can therefore correct any double symbol erasures, which Blaum calls phased erasures. The problem with these codes is that erasure decoding cannot be parallelized due to their cyclic dependencies. One approach not having this restriction is Blaum's "EVENODD: AN EFFICIENT SCHEME FOR TOLERATING DOUBLE DISK FAILURES IN RAID ARCHITECTURES", published in IEEE Trans Com-44, pp. 192-202, see also US Pat. No. 5,579,475. The latter approaches can be seen to have the disadvantage that EVENODD codes have at least some weight 1 columns in their parity check matrix, which is known to weaken the performance of message passing LDPC decoding.

Blaum also presented, in US 5,351,246, a generalization of the double erasure correcting codes to multiple erasure correcting codes.

The invention solves the problem of correcting one or two symbol erasures occurring within a codeword of a subclass of zArray Codes through algebraic decoding.

The invention has realized that a processing step from the zArray <u>en</u>coding approach, can actually be used - with minor modifications - to algebraically <u>de</u>code and correct codewords where up to two "symbols" are known to be defect. This form of decoding can actually be applied on any kind of LDPC encoded bits. But specifically, if the mentioned zArray codes have been used for ECC encoding, and the codeword bits are partitioned into symbols as described above, the zArray code properties enable that the processing is parallelizable into a number of parallel, independent sequences of bit operations, hence allowing high throughput.

The mentioned encoding processing step for zArray codes is based on the known requirement that $v \cdot H^T = 0$, i.e. that the codeword v to be generated, when GF2-multiplied with the transpose of the parity check matrix H, must result in a zero vector. The codeword v to be determined is split into 3 parts, one of which is the given information vector u. This is based on the notion that zArray codes are systematic codes, hence a zArray coded code vector v consists of the information vector u and some appended parity bits. The 2 parts of the codeword or code vector v that are not equal to the information vector u, are then derived in a recursive, but parallelizable way.

More specifically, zArray encoding an information word u into a code word v consisting of a first parity part vpar1, a second parity part vpar2, and the information word u, comprises the steps of: obtaining a first temporary vector w by GF2-multiplying the information word u with an information matrix Hinf; determining the second parity part vpar2 such that its GF2-product with a second parity matrix Hpar2 equals the first temporary vector w except at the (p-m + ((i· (2r+1)+q) mod p))-th vector elements; determining a second temporary vector w2 as the GF2-addition of the GF2-product of the second parity part vpar2 with the second parity matrix Hpar2 and the first temporary vector w; and determining the first parity part vpar1 such that its GF2-product with a first parity matrix Hpar1 equals the second temporary vector w2; wherein the information matrix Hinf comprises those (p-2)·(p-m) columns of the parity check matrix H that are associated to the information word u, the first parity matrix Hpar1 comprises the m-1 inserted or appended binary column vectors, and the second parity matrix Hpar2 comprises the remaining columns of the parity check matrix H.

zArray Codes were derived from a class of Smith's array codes having minimum distance 3. zArray codes have a design parameter m. When m is chosen as $m>1$, the minimum distance of zArray codewords is $d_{min}=2$, but the distance between most codewords is $d \geq 3$. This means that most combinations of two symbol erasures will be correctable, but not all of them.

The invention also addresses

- how to set the zArray Code parameter "r" in order to minimize the probability of two uncorrectable erasures. The resulting restriction defines a new subclass of zArray Codes;
- how to identify events where a double symbol erasure is uncorrectable due to insufficient code distance; and
- detecting decoding errors due to erroneous erasure information.

The latter can not be achieved with the teaching of US Pat. No. 5,271,012.

From an implementation point of view the invention also teaches how to parallelize the decoding of two symbol erasures by exploiting the zArray Code structure.

<u>Drawings</u>

Exemplary embodiments of the invention are illustrated in the drawings and are explained in more detail in the following description.

In the figures:

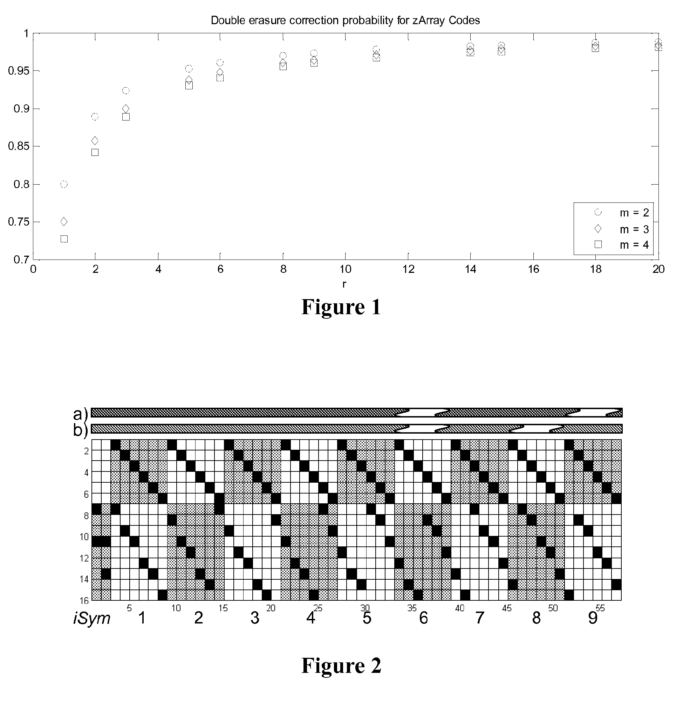

Figure 1    shows the double erasure correction probability of a subclass of zArray Codes.

Figure 2    shows the parity check matrix Hmz of a quasi-cyclic LDPC Code with m=3 and r=1, p=9. Ones are represented by black squares. White and grey squares represent Zeros. Bar a) symbolically illustrates an uncorrectable erasure of symbols 6 & 9; bar b) symbolically illustrates an uncorrectable erasure of symbols 6 & 8.

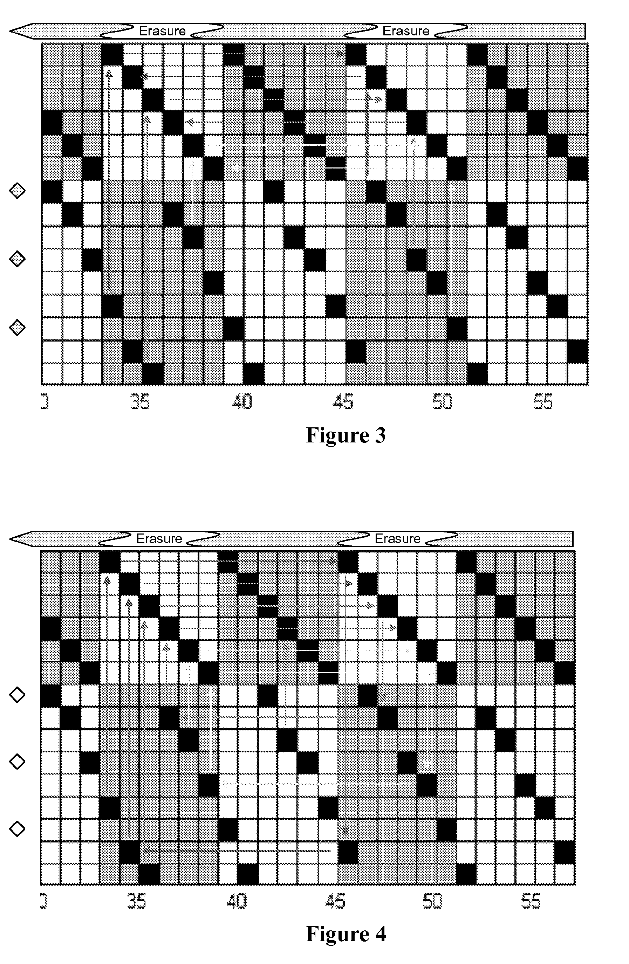

Figure 3    shows part of the parity check matrix Hmz of a quasi-cyclic LDPC Code with m=3 and r=1. Ones are represented by black squares. White and grey squares represent Zeros. Arrows denote the decoding schedule being done in 2m tasks. The diamonds on the left indicate rows involving vpar1. The bar on top illustrates the position of the erasures.

Figure 4    shows part of the parity check matrix Hmz of a quasi-cyclic LDPC Code with m=3 and r=1. Ones are represented by black squares. White and grey squares represent Zeros. Arrows denote the decoding schedule being done in 2m tasks. The diamonds on the left indicate rows involving vpar1. The bar on top illustrates the position of the erasures.

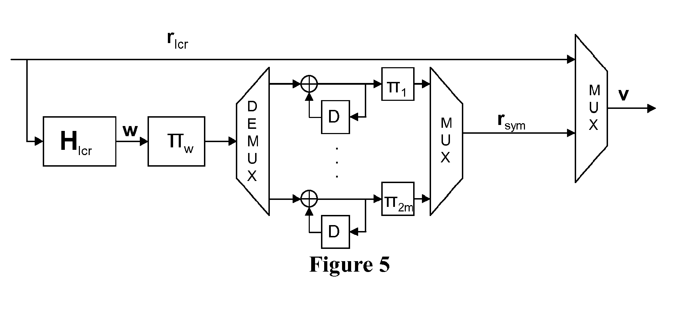

Figure 5    shows a block diagram for a 2m parallel implementation of the double erasure decoder.

Handling double symbol erasure does not essentially differ from the idea of the first encoding stage of zArray codes for finding $v_{par2}$. Nearly any other two symbols might be reconstructed (encoded) if $v_{par2}$ is known. For some combinations, no reconstruction schedule can be found due to $d_{min}=2$. The uncorrectable double erasure probability can be minimized though adjusting the design parameter $r$ to certain values. This introduces a new subclass of zArray Codes through sacrificing design freedom.

Within this subclass, decoding (if at all possible) can be parallelized into $2m$ tasks, equivalent to the $v_{par2}$ encoding process. Alternatively only $m$ task might be setup with decoding depth doubled.

Any single symbol erasure is correctable because of $d_{min}=2$. Erroneous bit positions within the symbol can be easily determined through the upper $(p-m)$ syndrome checks of $\mathbf{H}_{mz}$. It is also shown how the double erasure correction process can be used to correct single symbol erasures as well.

A symbol of a zArray codeword with index $x$ is defined to be a tuple comprising the $p-m$ bits corresponding to the submatrices $\mathbf{I''}$ or $\sigma^{(x-1)'}$ respectively. Note that in this nomenclature, $v_{par1}$ is not a symbol.

zArray codes can in many cases correct up to two symbol erasures by applying a strategy similar to the encoding process of $v_{par2}$. Erasures denote errors where the symbol position is known but the precise error pattern is not.

A $2m$ or $m$ task parallel schedule might be applied if two symbols of a codeword have been erased.

In some cases no decoding schedule might be found. Constraining the design parameter $r$ will minimize the occurrence probability of these cases. It will be shown how to identify these events for this subclass of zArray Codes.

The case of one erasure decoding is trivial, but it will be shown how the double erasure decoding process can also be used to correct every single erasure and detect decoding errors in case of erroneous erasure information.

**Defining a subclass of zArray Codes by setting design parameter r to maximize the correctable double erasure probability**

Figure 1 shows the double erasure correction probability of a subclass of zArray Codes.

The correctable double erasure probability can be brought to a maximum for a given $m$ if $r$ satisfies the following constraint:

$$(1 + 2\text{*}r) \text{ is prime} \quad (I)$$

This choice defines a subclass of zArray codes. It was found through extensive computer search that zArray Codes with parameters r not satisfying (I) have a much lower double erasure correction probability.

Notice that for $m>1$ neither $p=m+2mr$ nor $p-m$ are prime. This distinguishes zArray Code and its subclass from the traditional Array Codes by Smith and Blaum.

In the following, we will restrict ourselves to this subclass and assume that (I) holds. Then the number of uncorrectable double erasures is

$$t = (2r+1)\binom{m}{2}.$$

With the number of possible double erasure combinations

$$n = \binom{p}{2}$$

the correctable erasure probability reads

$$p_{\mathrm{cor}} = 1 - t/n\ .$$

For some *m* values, the correctable erasure probability can be taken from Figure 1.

### Identifying uncorrectable double symbol erasure

Figure 2 shows the parity check matrix Hmz of a quasi-cyclic LDPC Code with m=3 and r=1, p=9. Ones are represented by black squares. White and grey squares represent Zeros. Bar a) illustrates an uncorrectable erasure of symbols 6 & 9; bar b) illustrates an uncorrectable erasure of symbols 6 & 8.

Symbol indexing is defined to start with *iSym*=1 for the leftmost *p-m* bit tuple of $v_{par2}$, proceeds to *iSym*=2 for the rightmost *p-m* bit tuple of $v_{par2}$, then proceeds to *iSym*=3 for the leftmost *p-m* bit tuple of the information vector **u**, and ends at *iSym*=p for the rightmost *p-m* bit tuple of the information vector **u**.

A double symbol erasure is defined as a 2 element vector *iSymEra* denoting the indices of the erased symbols with *iSymEra(1) < iSymEra(2)*.

For a correctable double symbol erasure with r satisfying (I) the following condition must hold.

$$\text{mod}(\ (iSymEra(2) - iSymEra(1)),\ 2r+1) > 0 \qquad\qquad (II)$$

That is, *iSymEra(2) - iSymEra(1)* is not a multiple of *(2r+1)*.

This condition is not satisfied whenever the submatrices $\sigma^{(iSymEra(1)-1)}$ and $\sigma^{(iSymEra(2)-1)}$ have row-weight 0 within the same rows.

See Figure 2 for two examples :

    a) Within a codeword of a zArray Code with parameters *m*=3 and *r=1* symbols 6 & 9 have been erased. With *iSymEra* =[6, 9] condition (II) does not hold.

$$\text{mod}(9 - 6,\ 2*1+1) = 0$$

The double symbol erasure is uncorrectable.

    b) With *iSymEra* =[6, 8] condition (II) holds.

$$\text{mod}(8 - 6,\ 3) = 2$$

The double symbol erasure is correctable.

## Parallel erasure decoding utilizing vpar1

A double symbol erasure is given by *iSymEra* denoting the symbols being erased within the received vector **r.** The parity check equation $\mathbf{r}'\mathbf{H}_{mz}^{T} = \mathbf{0}$ must be fulfilled by setting the bits of symbols *iSymEra(1)* and *iSymEra(2)* accordingly. The codeword **r'** is decoded from **r** and is expected to equal the original codeword **v** in case of successful decoding.

With *iSymEra* the parity check matrix $\mathbf{H}_{mz}$ can be split into 5 parts

$$\mathbf{H}_{mz} = \begin{bmatrix} \mathbf{H}_{left} & \mathbf{H}_{sym1} & \mathbf{H}_{center} & \mathbf{H}_{sym2} & \mathbf{H}_{right} \end{bmatrix}$$

with

$$\mathbf{H}_{left} = \begin{bmatrix} \mathbf{I}'' & \cdots & & \mathbf{I}'' \\ \mathbf{Z} & \mathbf{I}' & \cdots & \sigma^{(iSymEra(1)-2)} \end{bmatrix} ,$$

$$\mathbf{H}_{sym1} = \begin{bmatrix} \mathbf{I}'' \\ \sigma^{(iSymEra(1)-1)} \end{bmatrix} ,$$

$$\mathbf{H}_{center} = \begin{bmatrix} \mathbf{I}'' & \cdots & & \mathbf{I}'' \\ \sigma^{iSymEra(1)} & \cdots & & \sigma^{(iSymEra(2)-2)} \end{bmatrix} ,$$

$$\mathbf{H}_{sym2} = \begin{bmatrix} \mathbf{I}'' \\ \sigma^{(iSymEra(2)-1)} \end{bmatrix}$$

and

$$\mathbf{H}_{right} = \begin{bmatrix} \mathbf{I}'' & \cdots & & \mathbf{I}'' \\ \sigma^{iSymEra(2)} & \cdots & & \sigma^{p-1} \end{bmatrix} .$$

This enables defining the matrices

$$\mathbf{H}_{lcr} = \begin{bmatrix} \mathbf{H}_{left} & \mathbf{H}_{center} & \mathbf{H}_{right} \end{bmatrix}$$

and

$$\mathbf{H}_{sym} = \begin{bmatrix} \mathbf{H}_{sym1} & \mathbf{H}_{sym2} \end{bmatrix} .$$

The vector $\mathbf{r}_{lcr}$ is extracted from $\mathbf{r}$ accordingly, i.e. $\mathbf{r}_{lcr}$ is received from $\mathbf{r}$ through removing of the erroneous *2\* (p-m)* symbol bits denoted by *iSymEra.* The naming "lcr" was chosen to symbolize the fact that removing two arbitrarily placed erased symbols from a codeword leaves a <u>l</u>eft part, a <u>c</u>enter part, and a <u>r</u>ight part. However, it must be noted, that depending on the position of the erasures, up to two of these parts can vanish because of having width 0.

With these definitions decoding can be done in 5 steps:

**Step 1:** Check if *iSymEra* satisfies condition (II). Break (i.e. exit) if (II) is violated.

**Step 2:** GF2-Multiply $\mathbf{r}_{lcr}$ and $\mathbf{H}_{lcr}$ to receive a temporary vector $\mathbf{w} = \mathbf{r}_{lcr}\mathbf{H}_{lcr}^{T}$ .

**Step 3:** Find $\mathbf{r}_{sym}$ recursively by solving

$$\mathbf{r}_{sym}\mathbf{H}_{sym}^{T} = \mathbf{w} \quad (III)$$

in $2m$ independent parallel tasks. Each row of $\mathbf{H}_{sym}$ having weight 1 serves a starting point for the different recursions resulting in 2r bits of $\mathbf{r}_{sym}$ each. One might also use only $m$ tasks if either rows from $\mathbf{H}_{sym1}$ or $\mathbf{H}_{sym2}$ are used to start the recursions. This will increase the recursion depth to 4r.

**Step 4:** Divide $\mathbf{r}_{sym}$ into $\mathbf{r}_{sym} = [\mathbf{r}_{sym1}\ \mathbf{r}_{sym2}]$. Interleave $\mathbf{r}_{sym1}$ and $\mathbf{r}_{sym2}$ into $\mathbf{r}_{lcr}$ according to the erasure positions memorized in *iSymEra,* yielding the corrected codeword **r'**.

**Step 5:** Perform post decoding syndrome check. Decoding is considered successful if $\mathbf{r'}\mathbf{H}_{mz}^{T} = \mathbf{0}$ holds. Otherwise a decoding error was detected. The syndrome check might be restricted to those rows of $\mathbf{H}_{mz}$ not involved in Step 3. All the others are satisfied through Step 3.

Notice that the capability of detecting a decoding error in case of erroneous erasure information will increase with a rising number of $\mathbf{v}_{par1}$ bits, i.e. greater $m$, since more rows of $\mathbf{H}_{mz}$ will not be taken into account in Step 3 thereby increasing the probability of finding a decoding error in Step 5.

For *m=1* there is no chance of detecting a decoding error.

Figure 3 shows part of the parity check matrix Hmz of a quasi-cyclic LDPC Code with m=3 and r=1. Ones are represented by black squares. White and grey squares represent Zeros. Arrows denote the decoding schedule being done in 2m tasks. The diamonds on the left indicate rows involving vpar1. The bar on top illustrates the position of the erasures. Figure 3 illustrates an example where the above Step 3 is executed in $2m$ tasks.

Figure 4 shows part of the parity check matrix Hmz of a quasi-cyclic LDPC Code with m=3 and r=1. Ones are represented by black squares. White and grey squares represent Zeros. Arrows denote the decoding schedule being done in 2*m* tasks. The diamonds on the left indicate rows involving vpar1. The bar on top illustrates the position of the erasures. Figure 4 illustrates an example where the above Step 3 is executed in *m* tasks.

A hardware realization for the Steps1-4 of the algorithm described above can be directly deduced from the block diagram shown in Figure 5. The vector **w** is generated by the block $\mathbf{H}_{lcr}$ which performs the GF2 matrix vector multiplication with $\mathbf{r}_{lcr}$. After interleaving **w** in block $\Pi_{w}$, a demultiplexer feeds a number of 2*m* (or *m*) XORs. The $\mathbf{r}_{sym\,then}$ results from interleaving and concatenation. Finally, **v** is found through multiplexing (interleaving) $\mathbf{r}_{sym1}$ and $\mathbf{r}_{sym2}$ into $\mathbf{r}_{lcr}$. Figure 5 shows a block diagram for a 2m parallel implementation of the double erasure decoder.

## Single erasure decoding

**Method A** Any single erasure indicated through a scalar *iSymEraSng* is correctable. The bit error pattern can easily be extracted from the *(p-m)* bit of the syndrome $\mathbf{s} = \mathbf{r}\mathbf{H}_{mz}^{T}$ corresponding to the upper *(p-m)* rows of $\mathbf{H}_{mz}$. Also check if the *p* bits of s corresponding to the lower *p* bits of $\mathbf{H}_{mz}$ indicate the same error pattern to identify false erasure information and thereby detect decoding errors.

**Method B** Single erasure decoding might also be accomplished through the 5 Steps described above by generating *iSymEra* form *iSymEraSng* by adding the right (or the left) neighboring symbol index.

$$iSymEra = [iSymEraSng \ (iSymEraSng+1)] \ , \qquad if \ iSymEraSng < p$$

$$iSymEra = [1 \ iSymEraSng] \ , \qquad\qquad\qquad if \ iSymEraSng = p$$

Notice: Neighboring two symbol erasures are always correctable!

In an additional **Step 6,** check if symbol *(iSymEraSng+1)* or *1* have been correctly restored to detect decoding errors.

The invention has realized that a processing step from the zArray <u>en</u>coding approach can actually be used - with minor modifications - to algebraically decode and correct codewords where up to two "symbols" are known to be defect. The properties of the zArray codes are such that the processing step can be parallelized into a number of parallel, independent sequences of bit operations, hence allowing high throughput.

However, some of the double erasure constellations are uncorrectable. But the invention has also recognized that the zArray Code parameter "r" strongly influences how many of all existing erasure constellations turn out to be uncorrectable. A rule for choosing "r" is given; the resulting subset of all possible zArray codes has a good double erasure correction probability. As by-products, the invention also describes a criterion by which the uncorrectable cases can be detected, and methods to reliably decode all cases of single erasure.

The invented methods extend the applicability of the zArray codes into those contexts where multiple erasures occur. Other than prior art double erasure decoders, the invented method is parallelizable <u>and</u> is based on codes suited for message passing decoding.

With other words, for correcting a multibit, LDPC coded codeword where up to two multibit symbols within the codeword are known to be erroneous, a method is proposed, where the position of the erroneous multibit symbols is checked for correctability, the non-erroneous subset of the codeword is GF2-multiplied with a corresponding subset of the parity check matrix of the LDPC code resulting in an interim vector, and the erroneous parts of the codeword are reconstructed such that they, when GF2-multiplied to their associated parts of the parity check matrix, yield the same interim vector.

**Claims**

1. A **method** for correcting an LDPC coded codeword where up to two symbols within the codeword are known to be erroneous, the method involving the following steps:

   - checking the position of the erroneous symbols for correctability, exiting if correctability is not given;
   - GF2-multiplying the non-erroneous subset of the codeword with a corresponding subset of the parity check matrix (H) of the LDPC code, resulting in an interim vector (w);
   - reconstructing the erroneous parts of the codeword such that they, when GF2-multiplied to their associated parts of the parity check matrix (H), yield the same interim vector (w).

2. A method according to claim 1, applied on codewords that were encoded with an LDPC code that is a zArray code, wherein the step of reconstructing is performed as more than one independent sequences of bit operations performed in parallel.

3. A method according to claim 2, where a code parameter (r) of the zArray code has been chosen such that 1 +2r is prime.

4. An **apparatus** for correcting a zArray coded codeword where up to two symbols within the codeword are known to be erroneous, the apparatus comprising:

   - A GF2-matrix vector multiplicator (Hlcr) equipped and configured to receive the received word (rlcr) and to derive therefrom an intermediate vector (w),
- An interleaver (Πw) equipped and configured to interleave the intermediate vector (w),
- a demultiplexer (DEMUX), a number of 2m (or m) of XORs, delay elements (D), and branch deinterleavers (Πi), the demultiplexer being equipped and configured to feed the XORs.
- A first multiplexer (MUX1) equipped and configured to concatenate the output of the branch deinterleavers (Πi), yielding a first corrected symbol (rsym1) and a second corrected symbol (rsym2), and
- a second multiplexer (MUX2) for deriving the corrected codeword (v) by multiplexing (interleaving) the first corrected symbol (rsym1) and the second corrected symbol (rsym2) into rlcr.

Double erasure correction probability for zArray Codes

**Figure 1**

**Figure 2**

**Figure 3**

**Figure 4**

**Figure 5**

Europäisches
Patentamt
European
Patent Office
Office européen
des brevets

**DECLARATION**

which under Rule 63 of the European Patent Convention
shall be considered, for the purposes of subsequent
proceedings, as the European search report

Application Number

EP 08 30 5689

| The Search Division considers that the present application, does not comply with the provisions of the EPC to such an extent that it is not possible to carry out a meaningful search into the state of the art on the basis of all claims | CLASSIFICATION OF THE APPLICATION (IPC) |
|---|---|
| Reason: | INV. H03M13/00 |

Claim 1 defines "A method for correcting an LDPC coded codeword where up to two symbols within the codeword are known to be erroneous", i.e. a method for LDPC erasure decoding. This definition allows that there other erroroneous symbols which are not known. This is usually the case in view of transmission errors due to noise etc. The second step of claim 1, however, refers to "the non-erroneous subset of the codeword". It is not clear why the symbols that have not been flagged as erasure should be non-erroneous. Erasures are merely a subset of all errors, namely those errors of which the location is known. Indeed, received LDPC codewords are usually soft sampled, so as to allow maximum likelihood decoding. Claim 1 does not define, nor does the description, what the input to the decoder is. Furthermore, LDPC codes are usually systematic, and if all symbols of a codeword are known to be correct, then what would be the purpose of decoding, i.e. error correcting, it? It is therefore not possible to understand this application.

The applicant's attention is drawn to the fact that a search may be carried out during examination following a declaration of no search under Rule 63 EPC, should the problems which led to the declaration being issued be overcome (see EPC Guideline C-VI, 8.2).
-----

| Place of search | Date | Examiner |
|---|---|---|
| The Hague | 16 February 2009 | Van Staveren, Martin |

EPO FORM 1504 (P04F37)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 9967913 A
- US 5271012 A
- EP 0519669 A
- US 5579475 A
- US 5351246 A

### Non-patent literature cited in the description

- **R.J.G. Smith.** Easily Decodable Efficient Self-Orthogonal Block Codes. *Electronics Letters,* 1977, vol. 13 (7), 173-174
- **Blaum's.** EVENODD: AN EFFICIENT SCHEME FOR TOLERATING DOUBLE DISK FAILURES IN RAID ARCHITECTURES. *IEEE Trans Com-44,* 192-202